# EUROPEAN PATENT APPLICATION

(11) **EP 4 815 662 A1**
(43) Date of publication of application: **30.09.2026**
(21) Application number: 26166829.7
(22) Date of filing: 23.03.2026
(51) Int. Cl.: H10D 1/68, H10W 20/41, H10W 20/40, H10D 84/90

(54) **ON-CHIP POWER SUPPLY NETWORK WITH COUPLING CAPACITOR**

(30) Priority: 26.03.2025 CN 202510371293
(71) Applicant: GigaDevice Semiconductor Inc., Haidian, Beijing (CN); GigaDevice Semiconductor (XIAN) Inc., Xi'an (CN); GigaDevice Semiconductor (Hefei) Inc., Hefei, Anhui (CN); Silead Inc., Shanghai 201210 (CN); Suzhou Freethink Information Technology Co., Ltd., Suzhou (CN)
(72) Inventor: CHEN, Fang, Beijing (CN)
(74) Representative: dompatent

(57) **Abstract**

An on-chip power supply network with coupling capacitor is provided, which includes at least one metal layer each including first and second metal strips extending in a first direction, first and second interdigitated metal fingers extending in a second direction intersecting the first metal strip. Ends of first and second interdigitated metal fingers are joined to first and second metal strips, respectively. One of the first and second metal strips provides power line, and the other provides grounding line. Between adjacent first and second metal strips, a number of first interdigitated metal fingers joined to the first metal strip and a number of second interdigitated metal fingers joined to the second metal strip are provided, the number of first and second interdigitated metal fingers are alternately arranged in a direction in which the first metal strip extends, thereby forming a power-to-ground coupling capacitor.

## Description

### TECHNICAL FIELD

The present invention relates to the field of integrated circuit technology and, in particular, to an on-chip power supply network with coupling capacitor.

### BACKGROUND

For integrated circuits, it is extremely important to provide components with a robust power supply network and to filter out and suppress power supply noise. In order to suppress interfering noise from an external power supply for an integrated circuit, one or more coupling capacitors are typically added to the circuit to provide power supply filtering, thereby obtaining a clean power supply voltage. Conventionally, power supply filtering is usually achieved by adding one or more on-chip metal-oxide-semiconductor field-effect transistor (MOSFET), metal-oxide-metal (MOM), metal-insulator-metal (MIM) or other capacitors. However, conventional methods for adding such capacitances tend to lead to increases in chip area and cost.

### SUMMARY OF THE INVENTION

It is an object of the present invention to provide an on-chip power supply network with coupling capacitor, which can provide both power and large coupling capacitor without additionally occupying any chip area.

To this end, the present invention provides an on-chip power supply network with coupling capacitor, which comprises at least one metal layer, each metal layer comprises: at least one first metal strip; at least one second metal strip, wherein each first metal strip and each second metal strip extend in a first direction; a plurality of first interdigitated metal fingers, for each first interdigitated metal finger, wherein the first interdigitated metal finger extends in a second direction intersecting the first metal strip, and wherein one end of the first interdigitated metal finger is joined to a side edge of the first metal strip; and a plurality of second interdigitated metal fingers, for each second interdigitated metal finger, wherein the second interdigitated metal finger extends in the same direction as the first interdigitated metal finger, and wherein one end of the second interdigitated metal finger is joined to a side edge of the second metal strip, wherein one of the first metal strip and the second metal strip provides a power line of the on-chip power supply network, and the other provides a grounding line of the on-chip power supply network, and wherein between adjacent first and second metal strips, a number of first interdigitated metal fingers joined to the first metal strip and a number of second interdigitated metal fingers joined to the second metal strip are provided, and wherein the number of first interdigitated metal fingers and the number of second interdigitated metal fingers are alternately arranged in a direction in which the first metal strip extends, thereby forming a power-to-ground coupling capacitor.

Optionally, the at least one metal layer may comprise at least two stacked metal layers, in adjacent metal layers, wherein: each of the first and second metal strips extends in the first direction and each of the first and second interdigitated metal fingers extends in the second direction in a lower metal layer; the first direction is perpendicular to the second direction; and each of the first and second metal strips extends in the second direction and each of the first and second interdigitated metal fingers extends in the first direction in the upper metal layer. In this way, adjacent metal layers can be stacked and more easily electrically connected to each other.

Optionally, the first metal strips of the lower and upper metal layers may be electrically connected by at least one via structure, and the second metal strips of the lower and upper metal layers may be electrically connected by at least one via structure. In this way, the adjacent metal layers can be electrically connected to each other. According to such embodiments, the on-chip power supply network including at least two stacked metal layers, which can provide robust power supply in both the first and second directions. Moreover, the coupling capacitor of the metal layers may be combined to provide even greater coupling capacitance. Alternatively, the upper and lower metal layers may correspond to different power supply networks for the chip. This configuration can meet the power supply requirements of multiple power supply networks in the chip and provide a relatively large coupling capacitance for each power network. Optionally, each metal layer may comprise at least one power supply unit each comprising one first metal strip and two second metal strips located on opposite sides of the first metal strip, wherein between the first metal strip and each second metal strip in each power supply unit, a number of first interdigitated metal fingers and a number of second interdigitated metal fingers are provided. In this way, each power supply unit has coupling capacitor, enhancing the performance of the on-chip power supply network.

Optionally, the at least one metal layer may comprise at least two stacked metal layers, wherein each power supply unit of an upper metal layer is stacked right above a corresponding power supply unit of a lower metal layer. According to such embodiments, a chip area occupied by the two power supply units can be minimized.

Optionally, widths of the first and second metal strips may be determined by the magnitude of a current of the on-chip power supply network. Alternatively or additionally, a width of the first or second interdigitated metal fingers may be less than the width of the first or second metal strip(s). This enables the on-chip power supply network to provide predefined power while having large coupling capacitor.

Optionally, each power supply unit in each metal layer may occupy an equal layout area. According to such embodiments, the power supply units in the metal layers can be stacked in a chip area-saving manner.

Optionally, each metal layer may comprise a plurality of power supply units arranged into an array, with the first direction in which the first metal strips extend being defined as a column-wise direction, wherein the first metal strips in each column are interconnected, and the second metal strips in each column are interconnected. According to such embodiments, the plurality of power supply units arranged in an array, can provide robust power supply in both transverse and longitudinal directions of the chip and even greater coupling capacitance per unit area.

Optionally, in adjacent metal layers, each metal layer may comprise a plurality of power supply units arranged into an array. According to such embodiments, more robust power supply and more stable coupling capacitor can be provided.

Optionally, each column of the first metal strips in the upper metal layer is electrically connected to at least two columns of the first metal strips in the lower metal layer by at least one via structure; and wherein each column of the second metal strips in the upper metal layer is electrically connected to at least two columns of the second metal strips in the lower metal layer by at least one via structure. In this way, interconnection of the first metal strips in the metal layers, interconnection of the second metal strips in the metal layers, interconnection of the first metal strips within each layer and interconnection of the second metal strip within each layer can be achieved.

Optionally, each first metal strip in the lower metal layer may be provided with a bonding pad which is connected to a corresponding first metal strip, and/or each second metal strip in the lower metal layer may be provided with a bonding pad which is connected to a corresponding second metal strip, wherein the via structure is provided on the bonding pad. According to such embodiments, the metal strips in the lower and upper layers can be electrically connected in a more stable way.

Optionally, in each metal layer, each first interdigitated metal finger may have an equal length and an equal width and each second interdigitated metal finger may have an equal length and an equal width.

Optionally, the metal layer may be a conductive layer of the chip and covers a component of the chip, and wherein the component is electrically connected to at least one of the first metal strip and the second metal strip. According to such embodiments, the on-chip power supply network can provide all power that the component requires and power-to-ground coupling capacitor without additionally occupying any chip area.

Optionally, a first terminal of the component may be electrically connected to the first metal strip by a via structure and/or a second terminal of the component may be electrically connected to the second metal strip by a via structure. In this way, the component can be electrically connected to the on-chip power supply network.

Optionally, the component may comprise a substrate and a gate structure formed on the substrate, the substrate containing source/drain regions on opposite sides of the gate structure. In this way, a MOS device can be electrically connected to the proposed on-chip power supply network.

In the present invention, there is provided an on-chip power supply network with coupling capacitor, which includes at least one metal layer each including at least one first metal strip, at least one second metal strip, a plurality of first interdigitated metal fingers and a plurality of second interdigitated metal fingers. The first and second metal strips all extend in the same direction. Each first interdigitated metal finger extends in a direction intersecting the first metal strip, with its one end being joined to a side edge of the first metal strip. Each second interdigitated metal finger extends in the same direction as the first interdigitated metal fingers, with its one end being joined to a side edge of the second metal strip. One of the first metal strip and the second metal strip provides power line, and the other provides grounding line. Between adjacent first and second metal strips, a number of first interdigitated metal fingers joined to the first metal strip and a number of second interdigitated metal fingers joined to the second metal strip are provided. A number of first interdigitated metal fingers and A number of second interdigitated metal fingers are alternately arranged in a direction in which the first metal strip extends, thereby forming a power-to-ground coupling capacitor. With this arrangement, the power-to-ground coupling capacitor is provided by alternately arranging first and second interdigitated metal fingers which are connected to the power and grounding connections, respectively, this allows the power and grounding lines and power-to-ground coupling capacitor to be combined in each single metal layer. Thus, the on-chip power supply network can provide both power and large coupling capacitor without additionally occupying any chip area. Accordingly, the chip is allowed to have a reduced area and be lower in cost, and is therefore expected to be more competitive.

### BRIEF DESCRIPTION OF THE DRAWINGS

Fig. 1 schematically illustrates a metal layer in an on-chip power supply network with coupling capacitor according to an embodiment of the present invention.
Fig. 2 schematically illustrates another metal layer in the on-chip power supply network according to the embodiment of the present invention.
Fig. 3 schematically illustrates the metal layers of Figs. 1 and 2, which are stacked one above the other.
Fig. 4 schematically illustrates an arrangement of multiple power supply units of a metal layer in an on-chip power supply network with coupling capacitor according to an embodiment of the present invention.
Fig. 5 schematically illustrates an arrangement of multiple power supply units of another metal layer in the on-chip power supply network according to the embodiment of the present invention.
Fig. 6 schematically illustrates the metal layers of Figs. 4 and 5, which are stacked one above the other.
Fig. 7 shows a schematic perspective view of an on-chip power supply network with coupling capacitor according to an embodiment of the present invention.

In these figures, 10-a power supply unit; 101- a first metal strip; 102-a second metal strip; 103-a first interdigitated metal finger; 104-a second interdigitated metal finger; 105-a bonding pad; 106-a via structure; 201-a substrate; 202-a source/drain region; and 203-gate structure.

### DETAILED DESCRIPTION

On-chip power supply networks with coupling capacitor according to specific embodiments of the present invention will be described in greater detail below with reference to the accompanying drawings. From the following description, advantages and features of the present invention will be more apparent. Note that the figures are provided in a very simplified form not necessarily drawn to exact scale for the only purpose of helping to explain the disclosed embodiments in a more convenient and clearer way.

As used herein, the singular forms "a", "an" and "the" include plural referents, and the term "a number of" is generally employed in the sense of "at least one", and "at least two" is generally employed in the sense of "two or more". Additionally, the use of the terms "first", "second" and "third" herein is intended for illustration only and is not to be construed as denoting or implying relative importance or as implicitly indicating the numerical number of the referenced items.

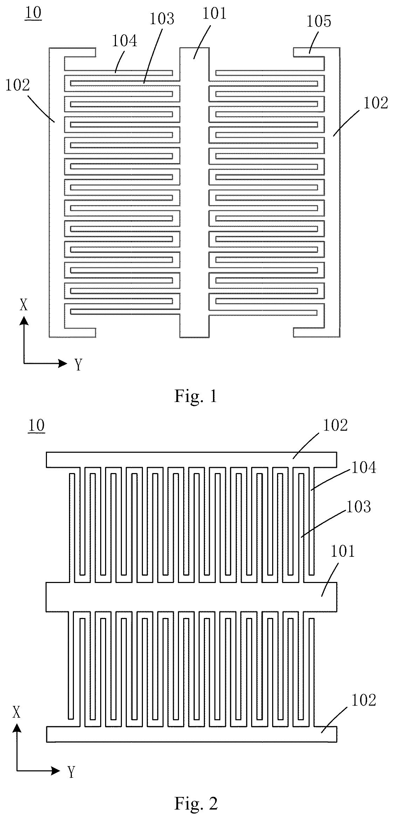

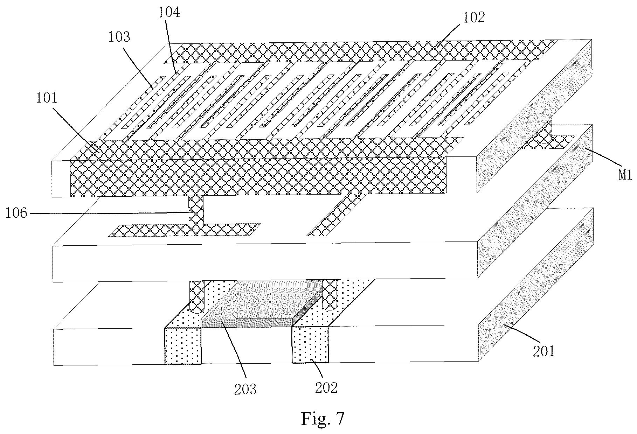

Fig. 1 schematically illustrates a metal layer in an on-chip power supply network with coupling capacitor according to an embodiment of the present invention. Fig. 7 shows a schematic perspective view of the on-chip power supply network with coupling capacitor according to the embodiment of the present invention.

Referring to Figs. 1 and 7, in this embodiment, the on-chip power supply network with coupling capacitor includes at least one metal layer each including at least one first metal strip 101, at least one second metal strip 102, a plurality of first interdigitated metal fingers 103 and a plurality of second interdigitated metal fingers 104. The first metal strip 101 and the second metal strip 102 both extend in the first direction. Each first interdigitated metal finger 103 extends in a second direction intersecting the first metal strip 101 and is joined at its one end to one side of the first metal strip 101. Each second interdigitated metal finger 104 extends in the same direction as the first interdigitated metal fingers 103 and is joined at its one end to one side of the second metal strip 102. One of the first metal strip 101 and the second metal strip 102 serves as a power line, and the other as a grounding line, for the on-chip power supply network. Between adjacent first metal strip 101 and second metal strip 102, there are provided a number of first interdigitated metal fingers 103 joined to the first metal strip 101 and a number of second interdigitated metal fingers 104 joined to the second metal strip 102. The first interdigitated metal fingers 103 and the second interdigitated metal fingers 104 are alternately arranged along the first direction in which the first metal strip 101 extends, forming power-to-ground coupling capacitor.

A dielectric material is filled between the metal features of the metal layer, in particular between the first metal strip 101, the second metal strip 102, the first interdigitated metal fingers 103 and the second interdigitated metal fingers 104. Examples of the dielectric material may include, but are not limited to, silicon dioxide. Examples of the material of the metal layer may include, but are not limited to, copper.

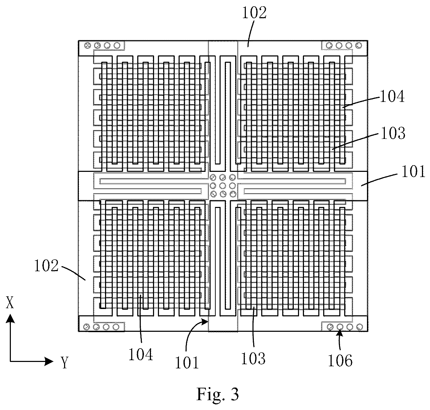

Fig. 2 schematically illustrates another metal layer in the on-chip power supply network of this embodiment. Fig. 3 schematically illustrates the metal layers of Figs. 1 and 2, which are stacked one above the other.

Referring to Figs. 1 to 3, the at least one metal layer may include two or more metal layers that are stacked together. As an example, the metal layer of Fig. 2 may be stacked above the metal layer of Fig. 1. Referring to Figs. 1 and 3, in adjacent metal layers, a lower metal layer may include: a first metal strip 101 and a second metal strip 102, both extending in a first (or X) direction; and first interdigitated metal fingers 103 and second interdigitated metal fingers 104, all extending in a second (or Y) direction. The first and second directions may be perpendicular to each other. Referring to Figs. 2 and 3, an upper metal layer located on the lower metal layer may include: a first metal strip 101 and a second metal strip 102, both extending the second direction; and first interdigitated metal fingers 103 and second interdigitated metal fingers 104, all extending in the first direction.

In the embodiment of Fig. 3, the metal lines in the upper metal layer are stacked above those in the lower metal layer. The metal lines include the first metal strip 101, the second metal strip 102, the first interdigitated metal fingers 103 and the second interdigitated metal fingers 104. The first metal strip 101 in the lower metal layer is electrically connected to the first metal strip 101 in the upper metal layer by via structure 106. The second metal strip 102 in the lower metal layer is electrically connected to the second metal strip 102 in the upper metal layer by via structure 106. Such an on-chip power supply network consisting of the two stacked metal layers can provide robust power supply in both the X and Y directions. Moreover, the coupling capacitor of the two metal layers can be combined to provide even greater coupling capacitor.

It should be noted that, in each single metal layer, a first metal strip 101 and an adjacent second metal strip 102 can function respectively as opposite plates of a capacitor, and the first interdigitated metal fingers 103 and second interdigitated metal fingers 104 function as interdigitated fingers of these capacitor plates, thereby significantly increasing coupling capacitance per unit area. Additionally, combining the coupling capacitor of the metal layers can provide an even greater capacitance.

In alternative embodiments of this application, the upper and lower metal layers may correspond to separate power supply networks for the chip. This arrangement can meet the power supply requirements of multiple power supply networks in the chip and provide a relatively large coupling capacitance for each power supply network.

An on-chip power supply network proposed herein may include one, two, three or another number of metal layers. In the case of three or more metal layers, metal strips in odd-numbered metal layers (e.g., M1 and M3) all extend in a single direction, and interdigitated metal fingers therein also all extend in a single direction. Likewise, metal strips in even-numbered metal layers (e.g., M2 and M4) all extend in a single direction, and interdigitated metal fingers therein also all extend in a single direction. The direction in which the metal strips in the odd-numbered metal layers extend may be perpendicular to the direction in which the metal strips in the even-numbered metal layers extend, and the direction in which the interdigitated metal fingers in the odd-numbered metal layers extend may be perpendicular to the direction in which the interdigitated metal fingers in the even-numbered metal layers extend.

In the embodiment illustrated in Figs. 1 and 3, the second metal strip 102 in the lower metal layer may be provided with a bonding pad 105, which is connected to the second metal strip 102. The bonding pad 105 may be located beside the second interdigitated metal fingers 104, and the via structures 106 for interconnecting the second metal strips 102 of the upper and lower layers may be provided on the bonding pad 105. A width and length of the bonding pad 105 may be appropriately determined according to the number of via structures 106 and a width thereof so that a reliability of the electrical connection between the metal strips in the upper and lower layers can be improved.

In some embodiments, the first metal strip 101 in the lower metal layer may be provided with another bonding pad 105, which is connected to the first metal strip 101. The bonding pad 105 may be located beside a number of the first interdigitated metal fingers 103, and the via structures 106 for interconnecting the first metal strips 101 of the upper and lower layers may be provided on the bonding pad 105.

It should be noted that the bonding pads 105 may be omitted from the first metal strip 101 and the second metal strip 102 in the lower metal layer. In this case, via structures 106 may be provided on overlapping portions of the first metal strips 101 in the upper and lower layers to interconnect the first metal strips 101. Moreover, via structures 106 may be provided on overlapping portions of the second metal strips 102 in the upper and lower layers to interconnect the second metal layers 102.

In embodiments, each metal layer may include at least one power supply unit. In the embodiment of Figs. 1 and 2, each metal layer includes one power supply unit 10. Referring to Figs. 1 and 2, each power supply unit 10 may include one first metal strip 101 and two second metal strips 102 located on opposite sides of the first metal strip 101. In each power supply unit, there are a number of first interdigitated metal fingers 103 and a number of second interdigitated metal fingers 104 between the first metal strip 101 and each of the two second metal strips 102. In each power supply unit 10, the first interdigitated metal fingers 103 and the second interdigitated metal fingers 104 on the same side of the first metal strip 101 are alternately arranged along the extension of the first metal strip 101. There may be equal numbers of first interdigitated metal fingers and equal numbers of second interdigitated metal fingers on both sides of the first metal strip. In each power supply unit 10, the number of first interdigitated metal fingers may be equal to the number of the second interdigitated metal fingers.

In some other embodiments, the number of first metal strips 101, the number of second metal strips 102, the number of first interdigitated metal fingers 103 and the number of second interdigitated metal fingers 104 in each power supply unit 10 may be determined as required in practical applications.

Referring to Fig. 3, in adjacent metal layers, the power supply unit 10 of the upper metal layer is stacked right above the power supply unit 10 of the lower metal layer. This can minimize a chip area occupied by the two power supply units 10. In alternative embodiments, the power supply unit 10 of the upper metal layer may partially overlap the power supply unit 10 of the lower metal layer.

Referring to Fig. 3, the power supply unit 10 of each metal layer may occupy the same area of the layout. This facilitates a smaller chip area occupied by the power supply units of the metal layers after they are stacked.

As a non-limiting example, as shown in Figs. 1 and 2, in each metal layer, each first interdigitated metal finger 103 may have an equal length and an equal width, and each second interdigitated metal finger 104 may also have an equal length and an equal width.

According to this application, the first and second metal strips 101, 102 may each have a width depending on the magnitude of a current of the corresponding on-chip power supply network. Thus, the strips in each metal layer may be designed with suitable widths, depending on the magnitude of a current of a corresponding power supply network for providing a power supply voltage (VDD) and the ground potential (VSS) of the power supply network. As an example, the first interdigitated metal fingers 103 may be narrower than either of the first and second metal strips 101, 102, and the second interdigitated metal fingers 104 may also be narrower than either of the first and second metal strips 101, 102.

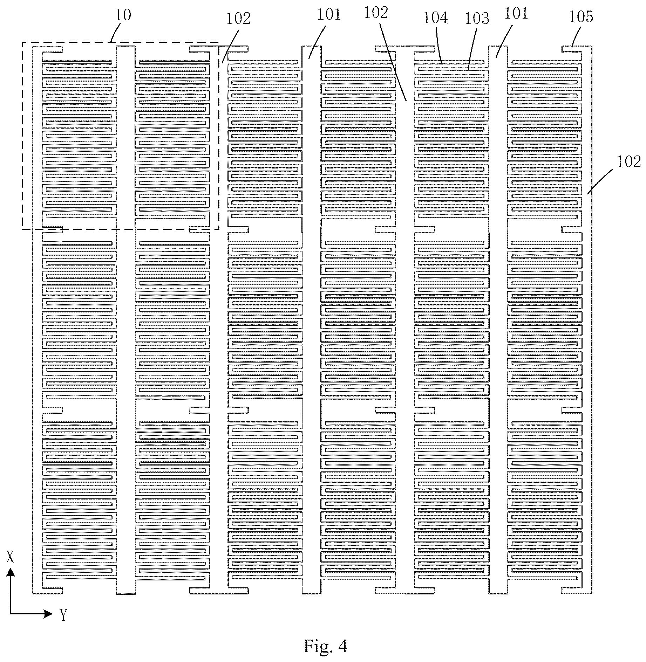

Fig. 4 schematically illustrates an arrangement of multiple power supply units of a metal layer in an on-chip power supply network with coupling capacitor according to an embodiment of the present invention.

In the embodiment of Fig. 4, one metal layer of the on-chip power supply network comprises a plurality of power supply units 10 that may be arranged into an array, with a first (or X) direction in which first metal strips extend being defined as a column-wise direction. These first metal strips 101 in each column are interconnected. Additionally, the second metal strips 102 in each column are interconnected. Arraying the power supply units 10 in this way enables efficient network layout design, and the resulting power supply network can provide robust power supply in both transverse and longitudinal directions of the chip and even greater coupling capacitor per unit area.

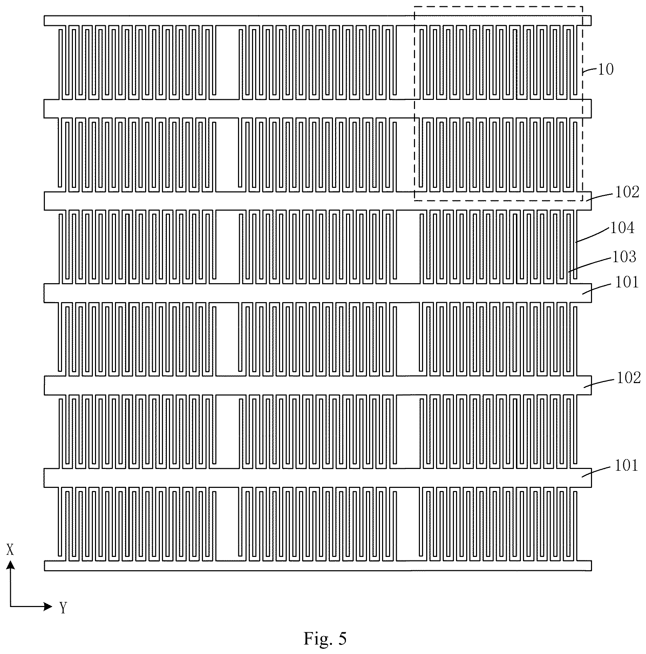

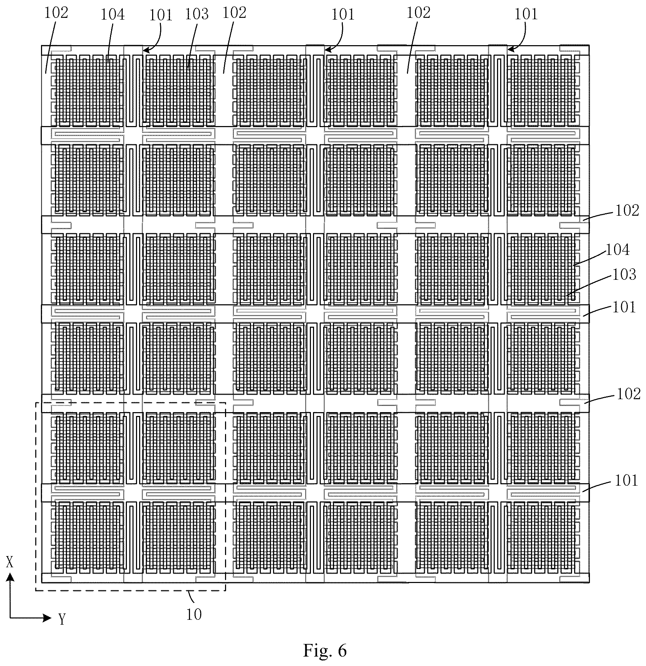

Fig. 5 schematically illustrates an arrangement of multiple power supply units of another metal layer in the on-chip power supply network according to this embodiment. Fig. 6 schematically illustrates the metal layers of Figs. 4 and 5, which are stacked one above the other. Referring to Figs. 4, 5 and 6, each layer of the stacked layers comprises multiple the power supply units arranged into an array. Each power supply unit 10 in the upper metal layer is stacked right above a corresponding power supply unit 10 in the lower metal layer. This facilitates robust power supply and stable coupling capacitor.

Referring to Fig. 6, out of the two stacked metal layers, each column of first metal strips 101 in the upper metal layer is electrically connected to two or more columns of first metal strips 101 in the lower metal layer by via structures (not shown in Fig. 6). Additionally, each column of second metal strips 102 in the upper metal layer is electrically connected to two or more columns of second metal strips 102 in the lower metal layer by via structures (not shown in Fig. 6). In this way, interconnection of first metal strips 101 in the two metal layers, interconnection of second metal strips 102 in the two metal layers, interconnection of first metal strips 101 within each layer and interconnection of second metal strip within each layer can be achieved.

Fig. 7 shows an on-chip power supply network with coupling capacitor proposed herein, the metal layer may be a conductive metal layer of the chip and may cover a component on the chip. The component is electrically connected to a first metal strip 101 and/or a second metal strip 102 in the metal layer. The on-chip power supply network composed of the first metal strip 101, the second metal strip 102, first interdigitated metal fingers 103 and second interdigitated metal fingers 104 provides all power that the chip or the component thereon requires and power-to-ground coupling capacitor without additionally occupying any chip area.

Specifically, if required, the component may be electrically connected to only the first metal strip 101, or be electrically connected to only the second metal strip 102, or be electrically connected to both the first metal strip 101 and the second metal strip 102. For example, a first terminal of the component may be electrically connected to the first metal strip 101 by an associated via structure, and/or a second terminal of the component may be electrically connected to the second metal strip 102 by an associated via structure.

Examples of the component on the chip may include, but are not limited to, MOS transistors, triodes, diodes, resistors and varactors. The on-chip power supply network may cover one or more components on the chip, and be electrically connected to one or more components on the chip that are covered.

As an example, referring to Fig. 7, the component includes a substrate 201 and a gate structure 203 formed on the substrate 201. The substrate 201 has an active area optionally containing source/drain regions 202 on opposite sides of the gate structure 203, which may be electrically connected to the first metal strip 101 and/or the second metal strip 102 by associated via structures 106. Referring to Fig. 7, each source/drain region 202 may be electrically connected to a metal layer M1 that is closest to the substrate 201 by an associated via structure 106, and the metal layer M1 may be in turn electrically connected to the first metal strip 101 and/or the second metal strip 102 located above the metal layer M1 by an associated via structure 106. In this case, the metal layer containing the first metal strip 101 and the second metal strip 102 may be located above the metal layer M1. In alternative embodiments, the first metal strip 101 and the second metal strip 102 may formed on the metal layer M1, and the active area in the substrate 201 may be directly electrically connected to the first metal strip 101 and/or the second metal strip 102 by a via structure 106.

In the present invention, there is provided an on-chip power supply network with coupling capacitor, which includes at least one metal layer each including at least one first metal strip 101, at least one second metal strip 102, a plurality of first interdigitated metal fingers 103 and a plurality of second interdigitated metal fingers 104. The first and second metal strips 101, 102 extend in the same direction. Each first interdigitated metal finger 103 extends in a direction intersecting the first metal strip(s) 101, with its one end being joined to a side edge of the first metal strip(s) 101. Each second interdigitated metal finger 104 extends in the same direction as the first interdigitated metal fingers 103, with its one end being joined to a side edge of the second metal strip(s) 102. One of the first metal strip(s) 101 and the second metal strip(s) 102 provides power line(s), and the other provides grounding line(s). Between adjacent first metal strip(s) 101 and second metal strip(s) 102, there are a number of the first interdigitated metal fingers 103 joined to the first metal strip 101 and a number of the second interdigitated metal fingers 104 joined to the second metal strip 102. The first interdigitated metal fingers 103 and the second interdigitated metal fingers 104 are alternately arranged in the direction in which the first metal strip 101 extends, thereby forming power-to-ground coupling capacitor. With this arrangement, the power-to-ground coupling capacitor is provided by alternately arranging first and second interdigitated metal fingers which are connected to the power and grounding connections, respectively, this allows the power and grounding lines and power-to-ground coupling capacitor to be combined in each single metal layer. Thus, the on-chip power supply network can provide both power and large coupling capacitor without additionally occupying any chip area. Accordingly, the chip is allowed to have a reduced area and be lower in cost, and is therefore expected to be more competitive.

It should be noted that reference throughout this specification to "one embodiment" or "this embodiment" means that a particular feature, structure, or characteristic described in connection with the embodiment is included in at least one embodiment. Thus, appearances of the phrases "one embodiment" and "this embodiment" in various places throughout this specification are not necessarily all referring to the same embodiment. Furthermore, the particular features, structures or characteristics may be combined in any suitable manner with one or more embodiments.

While the invention has been described above with reference to several preferred embodiments, it is not intended to be limited to these embodiments in any way. In light of the teachings hereinabove, any person of skill in the art may make various possible variations and changes to the disclosed embodiments without departing from the scope of the invention. Accordingly, any and all such simple variations, equivalent alternatives and modifications made to the foregoing embodiments without departing from the scope of the invention are intended to fall within the scope thereof.

## Claims

1. An on-chip power supply network with coupling capacitor, comprising at least one metal layer, wherein each metal layer comprises:
at least one first metal strip (101);
at least one second metal strip (102), wherein each first metal strip (101) and each second metal strip (102) extend in a first direction (X);
a plurality of first interdigitated metal fingers (103), for each first interdigitated metal finger (103), wherein the first interdigitated metal finger (103) extends in a second direction (Y) intersecting the first metal strip (101), and wherein one end of the first interdigitated metal finger (103) is joined to a side edge of the first metal strip (101); and
a plurality of second interdigitated metal fingers (104), for each second interdigitated metal finger (104), wherein the second interdigitated metal finger (104) extends in the same direction as the first interdigitated metal finger (103), and wherein one end of the second interdigitated metal finger (104) is joined to a side edge of the second metal strip (102),
wherein one of the first metal strip (101) and the second metal strip (102) provides a power line of the on-chip power supply network, and the other provides a grounding line of the on-chip power supply network, and wherein between adjacent first and second metal strips (101,102), a number of first interdigitated metal fingers (103) joined to the first metal strip (101) and a number of second interdigitated metal fingers (104) joined to the second metal strip (102) are provided, and wherein the number of first interdigitated metal fingers (103) and the number of second interdigitated metal fingers (104) are alternately arranged in a direction in which the first metal strip (101) extends, thereby forming a power-to-ground coupling capacitor.

2. The on-chip power supply network with coupling capacitor of claim 1, wherein the at least one metal layer comprises at least two stacked metal layers, in adjacent metal layers, wherein: each of the first and second metal strips (101,102) extends in the first direction (X) and each of the first and second interdigitated metal fingers (103,104) extends in the second direction (Y) in a lower metal layer; the first direction (X) is perpendicular to the second direction (Y); and each of the first and second metal strips (101,102) extends in the second direction (Y) and each of the first and second interdigitated metal fingers (103,104) extends in the first direction (X) in the upper metal layer.

3. The on-chip power supply network with coupling capacitor of claim 2, wherein the first metal strips (101) of the lower and upper metal layers are electrically connected by at least one via structure (106), and the second metal strips (102) of the lower and upper metal layers are electrically connected by at least one via structure (106), or wherein the upper and lower metal layers correspond to different power supply networks for the chip.

4. The on-chip power supply network of claim with coupling capacitor 1 or 2, wherein each metal layer comprises at least one power supply unit (10), wherein each power supply unit (10) comprises one first metal strip (101) and two second metal strips (102) located on opposite sides of the first metal strip (101), wherein between the first metal strip (101) and each second metal strip (102) in each power supply unit (10), a number of first interdigitated metal fingers (103) and a number of second interdigitated metal fingers (104) are provided.

5. The on-chip power supply network with coupling capacitor of claim 3, wherein the at least one metal layer comprises at least two stacked metal layers, wherein each power supply unit (10) of an upper metal layer is stacked right above a corresponding power supply unit (10) of a lower metal layer.

6. The on-chip power supply network with coupling capacitor of any one of claims 1 to 4, wherein widths of the first and second metal strips (101,102) are determined by a magnitude of a current of the on-chip power supply network, and/or wherein a width of the first or second interdigitated metal finger (103,104) is less than the width of the first or second metal strip (101,102).

7. The on-chip power supply network with coupling capacitor of claim 4 or 5, wherein each power supply unit (10) in each metal layer occupies an equal layout area.

8. The on-chip power supply network with coupling capacitor of claim 4, wherein each metal layer comprises a plurality of power supply units (10) arranged into an array, wherein the first direction (X) in which the first metal strip (101) extends is defined as a column-wise direction, and wherein the first metal strips (101) in each column are interconnected and the second metal strips (102) in each column are interconnected.

9. The on-chip power supply network with coupling capacitor of claim 8, wherein in adjacent metal layers, each metal layer comprises a plurality of power supply units (10) arranged into an array.

10. The on-chip power supply network with coupling capacitor of claim 8, wherein each column of the first metal strips (101) in the upper metal layer is electrically connected to at least two columns of the first metal strips (101) in the lower metal layer by at least one via structure (106); and wherein each column of the second metal strips (102) in the upper metal layer is electrically connected to at least two columns of the second metal strips (102) in the lower metal layer by at least one via structure (106).

11. The on-chip power supply network with coupling capacitor of claim 3, wherein each first metal strip (101) in the lower metal layer is provided with at least one bonding pad (105) which is connected to a corresponding first metal strip (101), and/or each second metal strip (102) in the lower metal layer is provided with at least one bonding pad (105) which is connected to a corresponding second metal strip (102), and wherein the via structure (106) is provided on the bonding pad (105).

12. The on-chip power supply network with coupling capacitor of claim 1, wherein in each metal layer, each first interdigitated metal finger (103) has an equal length and an equal width and each second interdigitated metal finger (104) has an equal length and an equal width.

13. The on-chip power supply network with coupling capacitor of claim 1, wherein the metal layer is a conductive layer of the chip and covers a component of the chip, and wherein the component is electrically connected to at least one of the first metal strip (101) and the second metal strip (102).

14. The on-chip power supply network with coupling capacitor of claim 13, wherein a first terminal of the component is electrically connected to the first metal strip (101) by a via structure (106) and/or a second terminal of the component is electrically connected to the second metal strip (102) by a via structure (106).

15. The on-chip power supply network with coupling capacitor of claim 13, wherein the component comprises a substrate (201) and a gate structure (203) formed on the substrate (201), wherein the substrate (201) containing source/drain regions (202) on opposite sides of the gate structure (201).
